# EUROPEAN PATENT APPLICATION

(11) **EP 4 707 828 A1**
(43) Date of publication of application: **11.03.2026**
(21) Application number: 23935106.7
(22) Date of filing: 06.12.2023
(51) Int. Cl.: G01R 31/327, H04N 7/18, G01D 11/16

(54) **PORTABLE HANDHELD RAPID STATE DETECTION DEVICE FOR GIS APPARATUS**

(30) Priority: 24.04.2023 CN 202310453107
(71) Applicant: CSGES Operation Management Branch Company, Guangzhou, Guangdong 511400 (CN)
(72) Inventor: HOU, Menglong, Guangzhou, Guangdong 511400 (CN); WANG, Jingyu, Guangzhou, Guangdong 511400 (CN); XIE, Guodong, Guangzhou, Guangdong 511400 (CN); FENG, Wenyu, Guangzhou, Guangdong 511400 (CN); LI, Donglu, Guangzhou, Guangdong 511400 (CN); LIU, Xin, Guangzhou, Guangdong 511400 (CN); LIN, Yongjun, Guangzhou, Guangdong 511400 (CN)
(74) Representative: Cabinet Camus Lebkiri
(86) International application number: PCT/CN2023/136725
(87) International publication number: WO 2024/221939

(57) **Abstract**

The present invention belongs to the technical field of detection devices, and particularly relates to a portable handheld rapid state detection device for a GIS apparatus. The device comprises a detection camera, a GIS test tablet computer, an image analysis module, a data transmission module, and a fixing and limiting module, wherein an end of the detection camera protrudes to form a monitoring protrusion, which is provided with a camera lens and a light supplement lamp; and The monitoring protrusion is embedded into a knife switch observation hole, and the camera lens and the light supplement lamp are respectively embedded into a light supplement hole and a camera hole in the knife switch observation hole. By means of the present invention, the whole process of dynamic positional changes of a knife switch can be accurately and quickly determined, and the position of a GIS knife switch can be confirmed within 15 seconds, thereby facilitating the execution of an isolation operation and avoiding the problems of inaccurate opening and closing indications of the knife switch of the GIS apparatus and being time-consuming in terms of confirming opening and closing positions.

## Description

### TECHNICAL FIELD

The present disclosure relates to the technical field of detection devices, and in particular, to a portable and handheld device for rapidly detecting a state of GIS.

### BACKGROUND

Gas insulated switchgear (GIS) refers to "gas-insulated and metal-enclosed switchgear", which is mainly composed of a circuit breaker, a disconnector, an earthing switch, a transformer, an arrester, a busbar, a connector, and an outlet terminal. GIS is widely used not only in high-voltage and extra-high-voltage fields, but also in ultra-high-voltage fields. Compared with conventional open-type substations, GIS has the advantages of compact structure, small footprint, high reliability, flexible configuration, convenient installation, strong safety, strong environmental adaptability, and small maintenance workload.

GIS knife switch devices used in some existing power storage stations are located in closed chambers filled with inert gas, which have advantages such as compact structure, flexibility, maintenance-free and not affected by external environmental conditions. However, compared with conventional open-type knife switch devices, GIS knife switch devices are not intuitive, i.e., it is impossible to identify whether the GIS knife switch contact is opened or closed in place by directly observing the contact state of GIS knife switch contact. Once the contact is not opened or closed in place, the consequences are unimaginable. Therefore, it is particularly important to quickly and accurately identify whether the GIS knife switch is closed in place in the knife switch operations.

The observation for the GIS knife switch device is often carried out through a knife switch observation window disposed outside the closed chamber. However, the knife switch observation window is usually disposed at a relatively high position of the enclosed device, and a continuous observation is required until the power is exhausted. Therefore, the detection operation may be achieved by embedding a camera used for detection onto the knife switch observation window after the staff moves to the position of the knife switch observation window through a climbing frame. However, the combination between the camera used for detection and the knife switch observation window depends on the friction generated by the embeddings, so as to hold the camera in place, and thus the combination may be unstable during the long-term detection operation, or even drop of the camera or collision therebetween may occur, resulting in camera damage and thus affecting the normal detection operation.

### SUMMARY

In order to address the above technical problems to make up for the deficiencies in the existing technology, the present disclosure provides a portable and handheld device for rapidly detecting a state of GIS.

The present disclosure adopts the following technical solutions to address the above technical problems: a portable and handheld device for rapidly detecting a state of GIS includes: a detection camera, a GIS detection tablet, an image analysis module, a data transmission module, and a fixing and limiting module. An end portion of the detection camera protrudes to form a monitoring convex block, a camera lens and a fill light are provided on the monitoring convex block. The monitoring convex block is embedded into a knife switch observation hole, the camera lens and the fill light are embedded into a camera hole and a fill light hole in the knife switch observation hole, respectively. A protective cover is sleeved on an outside of the monitoring convex block.

The data transmission module is configured to transmit an image information captured by the detection camera to the GIS detection tablet. The image analysis module is deployed on the GIS detection tablet and configured to analyze the image information and determine a position change of a knife switch to be detected.

The fixing and limiting module is configured to assist the detection camera to be fixed in the knife switch observation hole. The fixing and limiting module includes a limiting sleeve which is in a shape of a cylinder and wraps around an outside of the detection camera.

A limiting ring wrapping around the monitoring convex block is disposed at an end portion of the limiting sleeve, a fixing magnet is disposed on an outer surface of the limiting ring, and an outer ring surface of the limiting ring is made of an elastic material.

Preferably, a sliding groove is provided on an inner sidewall of the limiting sleeve proximate to the limiting ring. A pressing ring is mounted on an annular opening portion of the limiting sleeve proximate to the limiting ring.

A vertical cross-section of the pressing ring is in an L-shape, an end of the pressing ring is embedded into the sliding groove and is slidably connected to the sliding groove, and another end of the pressing ring is in contact with an outer surface of the limiting ring.

A region surrounded between the pressing ring and the limiting ring defines a limiting cavity, a portion of an outer ring of the limiting ring is hollow and defines a fixing cavity, and the limiting cavity is in communication with the fixing cavity.

Preferably, a limiting air bladder is provided in the limiting cavity. The limiting air bladder has an annular shape and is in communication with an interior of the fixing cavity through a connecting pipe, and a control valve is provided in a middle portion of the connecting pipe.

Preferably, limiting bumps are uniformly arranged on an outer surface of a side wall of the fixing cavity, and an end portion of each of the limiting bumps is inclined in a direction away from the camera hole.

Preferably, a suction hole is provided on a portion of the pressing ring facing a surface of an end portion of the knife switch observation hole, and the suction hole is in communication with the fixing cavity.

Preferably, a sealing ring made of an elastic material is disposed on an outer surface of the suction hole.

Preferably, the fixing magnet is provided on the outer surface of the limiting ring and is located in an interior region of the limiting cavity. The fixing magnet is distributed annularly around a central axis of the limiting sleeve.

Preferably, a fixing claw is provided at an end portion of the limiting sleeve and is located outside the pressing ring. The fixing claw is made of an elastic material.

Preferably, anti-slip blocks are uniformly arranged on an inner surface of the fixing claw, and each of the anti-slip blocks has a sharp end and is made of a rubber material.

Preferably, a cleaning rod is provided on an end portion of the limiting sleeve away from the limiting ring, and a cleaning block is provided on an end portion of the cleaning rod. The cleaning block has a circular plate structure and an outer surface of the cleaning block is wrapped by a cleaning sleeve.

The present disclosure has the following beneficial effects:
1. In the portable and handheld device for rapidly detecting the state of GIS according to the present disclosure, the elastic portion of the outer ring of the limiting ring is in contact with the inner wall surface of the knife switch observation hole, increasing the relative friction therebetween, so that the limiting ring is embedded into the knife switch observation hole more stably. Moreover, the fixing magnet located on the outer surface of the limiting ring and the inner wall of the knife switch observation hole made of iron attract each other after the limiting ring is embedded, so that the limiting ring drives the monitoring convex block and even the whole detection camera to be more stably combined with the knife switch observation hole during the monitoring process, thereby providing a relatively stable capturing platform for the opening-closing detection operation of the knife switch device and ensuring the smooth progress of normal monitoring operations.
2. The portable and handheld device for rapidly detecting the state of GIS according to the present disclosure may accurately and quickly determine the whole process of dynamic change of the knife switch position, so that the confirmation time of the GIS knife switch position may reach within 15 seconds, facilitating to perform the isolation operation and avoiding the issue of inaccurate opening and closing indications of the GIS knife switch and the issue of taking a lot of time to confirm the opening and closing position.

### BRIEF DESCRIPTION OF THE DRAWINGS

The present disclosure will be further described in conjunction with the accompanying drawings.
FIG. 1 is a perspective view of the present disclosure.
FIG. 2 is a partially enlarged view of the circle A in FIG. 1.
FIG. 3 is a partial schematic view of a knife switch observation hole applied to the present disclosure.
FIG. 4 is a perspective view of the present disclosure.
FIG. 5 is a perspective view of a pressing ring, in accordance with the present disclosure.
FIG. 6 is a half-sectional view of the present disclosure in combination with a knife switch observation hole.
FIG. 7 is a partially enlarged view of the circle B in FIG. 6.
FIG. 8 is a perspective view of a detection camera, in accordance with the present disclosure.
FIG. 9 is a flow chart showing an operating process after starting of the present disclosure.

In figures: 1: detection camera, 11: monitoring convex block, 111: camera lens, 112: fill light, 113: protective cover, 2: fixing and limiting module, 211: sliding groove, 21: limiting sleeve, 22: limiting ring, 221: fixing cavity, 222: limiting bump, 23: fixing magnet, 24: pressing ring, 241: limiting cavity, 242: suction hole, 243: sealing ring, 25: limiting air bladder, 251: connecting pipe, 26: fixing claw, 261: anti-slip block, 27: cleaning rod, 271: cleaning block 272: cleaning sleeve, 3: knife switch observation hole, 31: fill light hole, 32: camera hole.

### DETAILED DESCRIPTION

The technical solutions in the embodiments of the present disclosure will be clearly and thoroughly described with reference to the accompanying drawings in the embodiments of the present disclosure. Apparently, the described embodiments are only some of, not all of the embodiments of the present disclosure. Based on the embodiments in the present disclosure, all other embodiments obtained by those skilled in the art without creative effort should fall within the scope of the present disclosure.

### Embodiment 1

A portable and handheld device for rapidly detecting a state of GIS is provided. GIS knife switch devices used in some existing power storage stations are provided in closed chambers filled with inert gas, which have advantages such as compact structure, flexibility, maintenance-free and not affected by external environmental conditions. However, compared with conventional open-type knife switch devices, GIS knife switch devices are not intuitive, i.e., it is impossible to identify whether the GIS knife switch contact is opened or closed in place by directly observing the contact state of GIS knife switch contact. Once the contact is not opened or closed in place, the consequences are unimaginable. Therefore, it is particularly important to quickly and accurately identify whether the GIS knife switch is closed in place in the knife switch operations.

The observation for GIS knife switch device is usually carried out through a knife switch observation window disposed outside the closed chamber. However, the knife switch observation window is usually disposed at a relatively high position of the enclosed device, and a continuous observation is required until the power is exhausted. Therefore, the detection operation may be achieved by embedding a camera used for detection onto the knife switch observation window after the staff moves to the position of the knife switch observation window through a climbing frame. However, the combination between the camera used for detection and the knife switch observation window depends on the friction generated by the embeddings, so as to hold the camera in place, and thus the combination may be unstable during the long-term detection operation, or even drop of the camera or collision therebetween may occur, resulting in camera damage and thus affecting the normal detection operation.

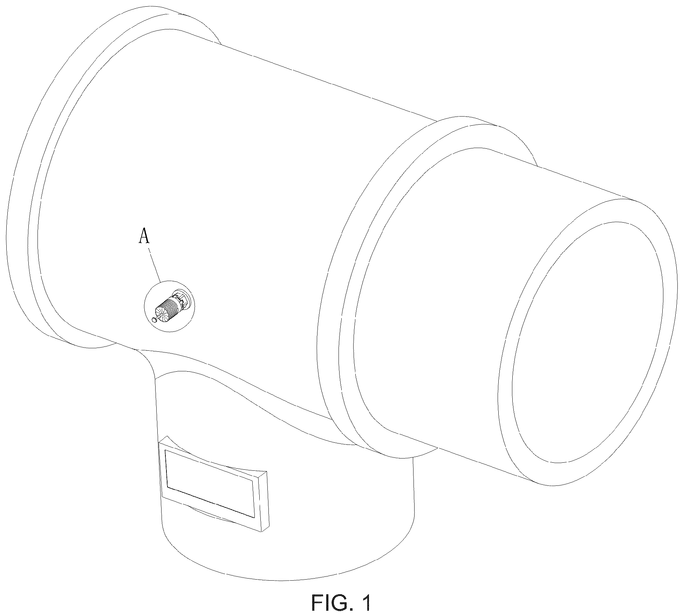

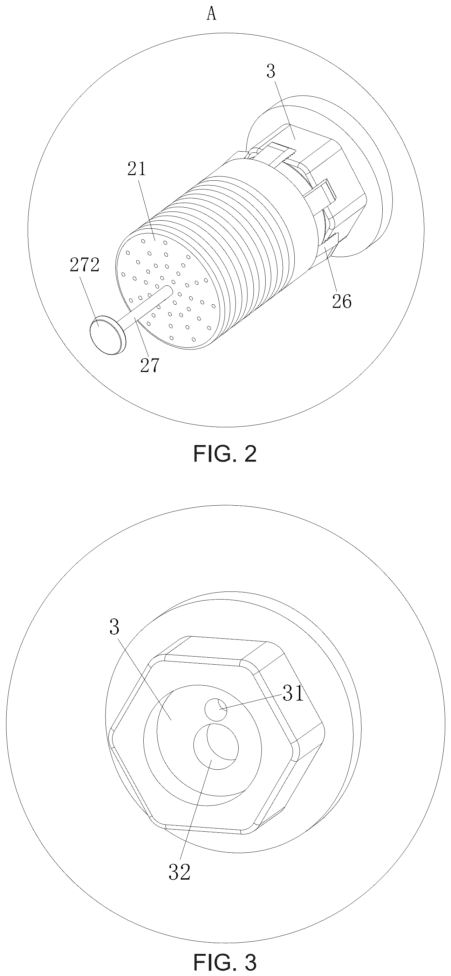

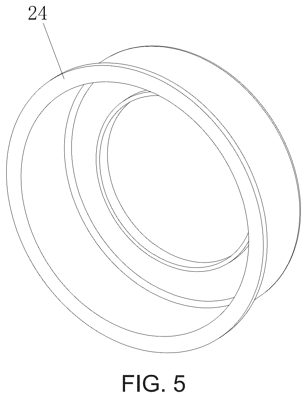

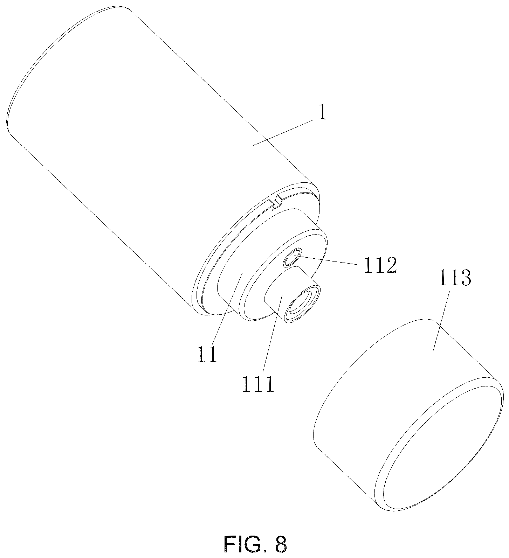

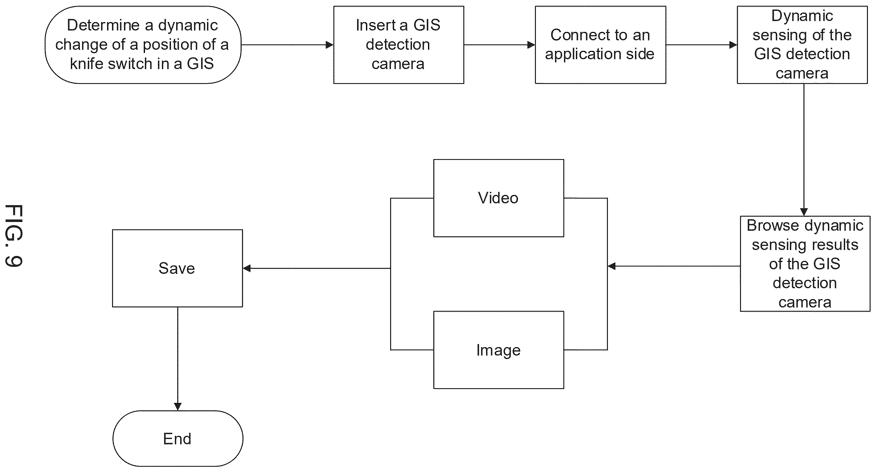

In order to effectively address the above issues, a portable and handheld device for rapidly detecting a state of GIS is provided in the present disclosure. As shown in FIGS. 1 to 9 in the drawings of the specification, the portable and handheld device for rapidly detecting the state of GIS includes a detection camera 1, a GIS detection tablet, an image analysis module, a data transmission module, and a fixing and limiting module 2. An end portion of the detection camera 1 protrudes to form a monitoring convex block 11. A camera lens 111 and a fill light 112 are provided on the monitoring convex block 11. The detection camera 1 adopts a dedicated GIS camera as a sensing end. The detection camera 1 aims at an application side, i.e., a location of the GIS knife switch.

The camera lens 111 and the fill light 112 are disposed at the end portion of the detection camera 1. A protective cover 113 is sleeved on an outside of the monitoring convex block 11, so as to protect the camera lens 111 and the fill light 112 therein, and the protective cover 113 may be removed during the operation. A knife switch observation hole 3 is provided on an outside of the closed chamber where the GIS knife switch device is located, as the application side. The knife switch observation hole 3 is provided with a fill light hole 31 and a camera hole 32. The fill light hole 31 and the camera hole 32 are in communication with an inside of the closed chamber, and a sealing glass is provided on the joint portion, so that the detection operation may be performed while ensuring the sealing of the interior of the closed chamber. In a case where the monitoring convex block 11 is embedded in the knife switch observation hole 3, the camera lens 111 and the fill light 112 may be embedded in the camera hole 32 and the fill light hole 31 of the knife switch observation hole 3, respectively, so as to observe and detect the GIS knife switch device in the closed chamber through the sealing glass.

The camera lens 111 may capture an operating state of the GIS knife switch device in the closed chamber through the knife switch observation hole 3. An LED light is selected as the fill light 112. In a case where the fill light 112 is turned on, the fill light 112 may illuminate the interior of the closed chamber through the sealing glass, thereby creating an operating environment with high brightness inside the closed chamber, which is conducive to capturing operations.

A data jack is disposed at another end portion of the detection camera 1, the data jack may be connected to a data cable for wired data transmission, so as to more stably transmit the captured video data, while charging the internal battery. A control button is further mounted on the detection camera 1, and the control button is responsible for adjusting the brightness of the fill light 112, starting and closing the detection camera 1, and other functions, which may be helpful for the operator to adjust according to the use environment, thereby improving the applicability of the detection camera 1 to the operating environment.

The data transmission module is configured to transmit the image information captured by the detection camera 1 to the GIS detection tablet. The operator holds the GIS detection tablet for observation under the equipment. An image analysis module is deployed on the GIS detection tablet, so as to analyze the transmitted image information and determine the position change of the knife switch to be detected.

The fixing and limiting module 2 is configured to assist the detection camera 1 to be fixed in the knife switch observation hole 3. The fixing and limiting module 2 includes a limiting sleeve 21 which is in a shape of a cylinder and wraps around the outside of the detection camera 1. A side wall of the limiting sleeve 21 may be made of materials with electromagnetic shielding effects, so as to reduce the adverse effects of the high electromagnetic environment on the normal internal operation of the detection camera 1, and to protect the detection camera 1 to reduce the damage to the detection camera 1 in case of collisions that occur during the installation process.

Ventilation holes are evenly disposed at an end portion of the detection camera 1 away from the knife switch observation hole 3, so that the internal and external environments of the limiting sleeve 21 are in communication with each other. The exchange of air plays a role in cooling the detection camera 1 in the limiting sleeve 21. Moreover, the end portion of the detection camera 1 away from the knife switch observation hole 3 is made of non-electromagnetic shielding material, and a transmitting end of the detection camera 1 is also provided here, which is conducive to wirelessly transmitting the image signal through the ventilation holes to the GIS detection tablet.

A limiting ring 22 wrapping around the monitoring convex block 11 is disposed at an end portion of the limiting sleeve 21. An end portion of the limiting ring 22 protrudes from the end portion of the monitoring convex block 11. In a case where the limiting ring 22 is embedded in the knife switch observation hole 3, the limiting ring 22 is embedded in the knife switch observation hole 3 prior to the end portion of the monitoring convex block 11. Moreover, a fixing magnet 23 and the limiting ring 22 are disposed on an outer surface of the limiting ring 22. An inner ring surface of the limiting ring 22 is made of hard material, so as to protect the monitoring convex block 11, and an outer ring surface of the limiting ring 22 is made of elastic material, such as rubber material.

Specific workflow is as follows: in a case where the GIS knife switch of an important power storage device located in the power storage station needs to be closed or opened, the operator moves to the position of the knife switch observation hole 3 on the closed chamber by means of a climbing frame, a ladder, or other tools, and then holds the limiting sleeve 21 and makes the limiting ring 22 protruding from the end portion of the limiting sleeve 21 to be aligned with and embedded in the knife switch observation hole 3, so that the monitoring convex block 11 on the monitoring convex block 11 is embedded in the knife switch observation hole 3. The fill light 112 and the camera lens 111 on the monitoring convex block 11 are aligned with and embedded in the fill light hole 31 and the camera hole 32 respectively, thereby facilitating the later detection operation.

During the embedding process, the end portion of the limiting ring 22 sleeved on the outer surface of the monitoring convex block 11 is embedded into the knife switch observation hole 3 prior to the monitoring convex block 11, and is in contact with an inner wall surface of the knife switch observation hole 3. The limiting ring 22 is then embedded along an inner extension direction of the knife switch observation hole 3, such that the monitoring convex block 11 is subjected to a limiting effect before embedding, and thus embedded along a stable motion trajectory.

Similarly, when the detection camera 1 is removed, the limiting ring 22 has not yet been completely slid out, while the monitoring convex block 11 has already separated from the knife switch observation hole 3 along a stable sliding trajectory. In this way, the movement of the monitoring convex block 11 along the stable and fixed motion trajectory may reduce lateral sway of the monitoring convex block 11 in the knife switch observation hole 3 during the manual embedding process, which is caused by insufficiently tight limit in embedding or removal operations, and results in that the embedded monitoring convex block 11, the fill light 112 and camera lens 111 on the monitoring convex block 11 collide with the inner wall of the knife switch observation hole 3 due to the sway. As a result, the damage of the monitoring convex block 11, and the fill light 112 and camera lens 111 on the monitoring convex block 11, due to collision with the inner wall of the knife switch observation hole 3, may be effectively reduced.

Furthermore, in the process of embedding installation, the elastic portion of the outer ring of the limiting ring 22 is in contact with the inner wall surface of the knife switch observation hole 3, increasing the relative friction therebetween, so that the limiting ring 22 is embedded into the knife switch observation hole 3 more stably. Moreover, the fixing magnet 23 located on the outer surface of the limiting ring 22 and the inner wall of the knife switch observation hole 3 made of iron are attracted to each other after the limiting ring 22 is embedded, so that the limiting ring 22 drives the monitoring convex block 11 and even the whole detection camera 1 to be more stably combined with the knife switch observation hole 3 during the monitoring process, thereby providing a relatively stable capturing platform for the opening-closing detection operation of the knife switch device and ensuring the smooth progress of normal monitoring operations.

The fill light 112 is turned on after the detection camera 1 is mounted, and the light passes through the corresponding sealing glass to illuminate the interior of the closed chamber. The camera lens 111 then captures the state of the interior of the closed chamber through the sealing glass on the camera hole 32. In the closing process of the knife switch, the iron rod-shaped movable contact extends out and is in contact with the stationary contact at the opposite position, so as to complete the closing and energization. During this process, the detection camera 1 captures images during the opening process and transmits the images to the GIS detection tablet, facilitating the observation of the operator, while the image analysis module deployed on the GIS detection tablet may analyze the images.

For example, a GIS knife switch state intelligent recognition application (APP) in the image analysis module may automatically recognize and display the opening and closing states of GIS knife switch through artificial intelligence (AI) algorithms during operation, so that the recognition of the opening and closing states of GIS knife switch may be upgraded from confirmation by user through eyes to system automatic recognition, improving recognition accuracy, and improving operating efficiency of the user by 80% or more.

In order to detect whether the knife switch is closed in place in real time, deep learning and semantic segmentation technologies may be used in combination with multi-segment exposure algorithms. The semantic segmentation algorithm will use NCNN quantization, and deploys the deep learning segmentation algorithm to the GIS detection tablet through a large number of pruning and model compression technologies.

The segmentation model uses the latest Pyramid Scene Parsing Network and has been optimized, so as to achieve a minimum detection accuracy of 10% of a length of the knife switch and a detection speed of 2 seconds per time (2s/time).

The present disclosure further supports the Al recognition function when the video is previewed in real time, so as to detect whether the knife switch is damaged in real time. Edge features of the knife switch are extracted by using deep learning feature extraction technology after the knife switch is in place. The distribution of all line segments is statistically calculated by using the differential slope statistical algorithm after the deep learning edge extraction, so as to determine whether the edge is damaged, thereby achieving the detection purpose. The minimum damage area for detection is 5% of the visual field area of the knife switch, and the detection time is 2s/time. Once the damage is found, the alarm is called in time to inform the observer to pay attention and stay away, and inform the maintenance personnel to cut off the power for maintenance of the equipment.

The Al recognition function is supported when the video is previewed in real time, so as to detect whether blockage caused by a foreign object in the slot occurs in real time, thereby preventing the foreign object from blocking and damaging the knife switch before the closing. This detection uses HSV color extraction algorithm to extract the color of the background, so as to form a template image. During the detection, HSV algorithm is used again to extract the color of the real-time detected image, and then the template image is compared with the processed image, so as to obtain a difference energy image. At last, an abnormal region is extracted by the adaptive binarization technology. In this algorithm, the minimum foreign object detection diameter is 20% of the length of the knife switch, and the detection time is 1s/time.

Through the algorithm, the colors of the highlight surface of the extending portion of the iron rod-shaped movable contact and the protective protruding surface plastic portion may be identified. The extending length of the iron rod-shaped movable contact and the position of the movable contact entering the static contact may be determined according to the position change of the above color portions during the closing process, so as to accurately determine whether the closing is in place.

The present disclosure may stably capture the operating process of the GIS knife switch device in the closed chamber, and accurately and quickly determine the whole process of dynamic change of the knife switch position, so that the confirmation time of the GIS knife switch position may be within 15 seconds, facilitating to perform the isolation operation and avoiding the issue of inaccurate opening and closing indications of the GIS knife switch device and the issue of taking a lot of time to confirm the opening and closing position.

### Embodiment 2

On the basis of embodiment 1, as shown in FIGS. 1 to 8 in the drawings of the specification, a sliding groove 211 is provided on an inner sidewall of the limiting sleeve 21 proximate to the limiting ring 22, and a pressing ring 24 is mounted on an annular opening portion of a limiting cavity 241 proximate to the limiting ring 22. A vertical cross-section of the pressing ring 24 is in an L-shape. One end of the pressing ring 24 is embedded into the sliding groove 211 and is slidably connected to the sliding groove 211 through a return spring, and another end of the pressing ring 24 is in contact with an outer surface of the limiting ring 22. A region surrounded between the pressing ring 24 and the limiting ring 22 defines a limiting cavity 241, a portion of an outer ring of the limiting ring 22 is hollow and defines a fixing cavity 221. The limiting cavity 241 is in communication with the fixing cavity 221.

Specific workflow is as follows: on the basis of the specific workflow in embodiment 1, in order to ensure the convenience of installation and removal of the detection camera 1 during work, a diameter of the outer ring surface of the limiting ring 22 may be selected to be less than an inner diameter of the knife switch observation hole 3. In this way, a gap is maintained between the outer ring surface of the limiting ring 22 and the inner wall of the knife switch observation hole 3 after the limiting ring 22 is embedded into the knife switch observation hole 3 with the monitoring convex block 11.

After that, the operator may push the limiting sleeve 21, so that the limiting sleeve is further embedded deeply into the knife switch observation hole 3. The limiting sleeve 21 is then pressed against the pressing ring 24 on the surface of the end portion of the knife switch observation hole 3. The pressing ring 24 slides under pressure, and the end portion of the pressing ring 24 embedded in the sliding groove 211 further presses the return spring to be further embedded into the sliding groove 211, so that the internal space of the limiting cavity 241 is reduced, the air inside the limiting cavity 241 flows into the fixing cavity 221 at the outer ring of the limiting ring 22. As a result, the air pressure inside the fixing cavity 221 increases and the fixing cavity 221 expands, the portion of the outer ring of the limiting ring 22 corresponding to the fixing cavity 221 is in close contact with the inner wall surface of the knife switch observation hole 3 due to expansion, which increases the relative friction between the limiting ring 22 and the inner wall of the knife switch observation hole 3, so that the limiting sleeve 21 may be mounted more stably.

Furthermore, a control valve is provided at a joint portion between the limiting cavity 241 and the fixing cavity 221, so as to control the airflow into the fixing cavity 221 to achieve the expansion of the fixing cavity 221. The control valve is activated to block the communication portion between the limiting cavity 241 and the fixing cavity 221 after the limiting ring 22 and the knife switch observation hole 3 are engaged with each other tightly, so as to ensure the inflation and expansion degree of the fixing cavity 221, so that the limiting sleeve 21 may be embedded more stably. The detection camera 1 and the knife switch observation hole 3 remain relatively stable during the monitoring operation, so that the monitoring operation for the knife switch device may be performed smoothly.

Furthermore, in a case where removal is required, only the control valve needs to be controlled and opened from the outside, so that the airflow located in the fixing cavity 221 returns to the interior of the limiting cavity 241. In an aspect, the relative friction between the limiting ring 22 and the inner wall of the knife switch observation hole 3 is reduced. In another aspect, the air pressure inside the limiting cavity 241 is increased to push the pressing ring 24 to move in a direction away from the knife switch observation hole 3, and drive the monitoring convex block 11 to slide away from the knife switch observation hole 3, so that the detection camera 1 may be removed more easily, avoiding damage to the detection camera 1 due to manual rough pulling out. In this way, the mounting and removing of the detection camera 1 with respect to the knife switch observation hole 3 may be more automatic and convenient, reducing the problems caused by manual operation errors during the installation and removal.

### Embodiment 3:

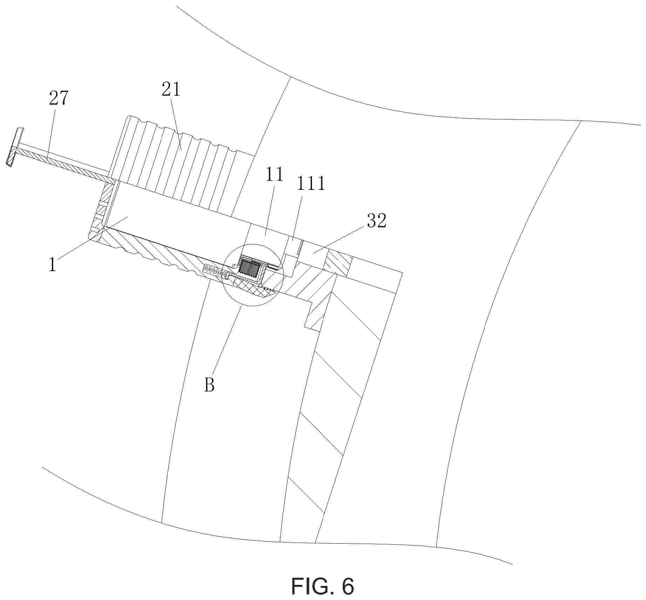

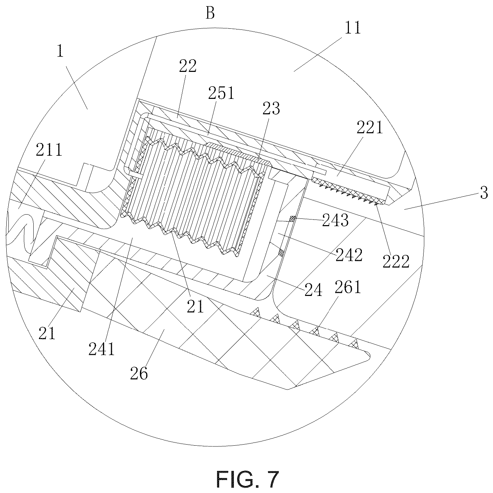

On the basis of embodiment 2, as shown in FIGS. 6 and 7 in the drawings of the specification, a limiting air bladder 25 is provided in the limiting cavity 241. The limiting air bladder 25 has an annular shape and is in communication with an interior of the fixing cavity 221 through a connecting pipe 251. A control valve is provided in a middle portion of the connecting pipe 251. Limiting bumps 222 are uniformly arranged on an outer surface of a side wall of the fixing cavity 221. For example, the limiting bumps 222 are uniformly distributed on a portion of the outer surface of the limiting ring 22 corresponding to the fixing cavity 221, and may be made of an elastic material such as rubber. An end portion of the limiting bump 222 is inclined in a direction away from the camera hole 32.

Specific workflow is as follow: on the basis of the specific workflow in embodiment 2, in order to further ensure that the airflow inside the limiting cavity 241 smoothly flows into the fixing cavity 221, the limiting air bladder 25 is provided inside the limiting cavity 241. When sliding, the pressing ring 24 contacts and squeezes the limiting air bladder 25, so that the limiting air bladder 25 is compressed to input airflow into the fixing cavity 221 through the connecting pipe 251 in communication with the interior of the fixing cavity 221, so as to control the internal expansion of the fixing cavity 221, thus fixing the limiting ring 22. In this way, through the limiting air bladder 25 with good sealing, it is avoided that the airflow inside the limiting cavity 241 flows out through the connection gap of the pressing ring 24 due to the pressure, which affects the control of air pressure.

Furthermore, in the removing process, the control valve is closed through an external controller, so that the airflow inside the fixing cavity 221 reversely enters the limiting air bladder 25 inside the limiting cavity 241 through the connecting pipe 251, and the limiting air bladder 25 expands and presses the pressing ring 24, and the pressing ring 24 pushes the surface of the end portion of the knife switch observation hole 3. This reverse action makes the end portion of the detection camera 1 to slide out, which facilitates the separation between the detection camera 1 and the knife switch observation hole 3. Moreover, since the limiting air bladder 25 has the good sealing performance, the limiting air bladder 25 may be filled with liquid therein. The liquid has a small compressibility. The fixing cavity 221 expands more obviously after the liquid enters the fixing cavity 221, so that the limiting ring 22 may be embedded into the knife switch observation hole 3 more tightly, and the detection camera 1 and the knife switch observation hole 3 are combined more stably during the monitoring operation, and the monitoring operation may be carried out more smoothly.

Furthermore, the limiting bumps 222 are uniformly arranged on the portion of the outer surface of the limiting ring 22 corresponding to the fixing cavity 221, and the end portions of the limiting bumps 222 are inclined. In this way, the end portions of the limiting bumps 222 are in contact with the inner surface of the knife switch observation hole 3 due to the expansion action and are combined with the inner surface more tightly after the fixing cavity 221 is expanded, further ensuring the stability of the detection camera 1 during the installation process, and thereby ensuring the smooth progress of the monitoring operation.

### Embodiment 4

On the basis of embodiment 3, as shown in FIGS. 6 and 7 in the drawings of the specification, a suction hole 242 is provided on a portion of the pressing ring 24 facing the surface of the end portion of the knife switch observation hole 3. The suction hole 242 is in communication with the fixing cavity 221. A sealing ring 243 made of an elastic material is disposed on an outer surface of the suction hole 242.

Specific workflow is as follows: on the basis of the specific workflow in embodiment 3, after the detection camera 1 is mounted on the knife switch observation hole 3, the portion of the pressing ring 24 provided with the suction hole 242 is in close contact with the surface of the end portion of the knife switch observation hole 3. When the pressing ring 24 is pushed, the limiting air bladder 25 in the pressing ring 24 is compressed, the volume of the limiting air bladder 25 decreases, and the internal space volume of the pressing ring 24 decreases. When the pressing is finished, the end portion of the pressing ring located in the sliding groove 211 has a reset tendency due to the action of the connected return spring, while when the pressing ring 24 is reset, the internal space of the pressing ring 24 increases but the air pressure decreases, which requires to supplement airflow from outside through the suction hole 242.

The sealing ring 243 provided on the outer ring surface of the suction hole 242 improves the sealing performance of the suction hole 242, so that it is difficult for external airflow to enter. Therefore, the negative pressure effect of the limiting cavity 241 in the pressing ring 24 makes the suction hole 242 and the surface of the end portion of the knife switch observation hole 3 in contact therewith be attracted to each other and be tightly fixed, further ensuring the stable combination between the limiting sleeve 21 and the knife switch observation hole 3. In a case where removal is required, it is only necessary to make the airflow in the limiting air bladder 25 to return, and the expanded limiting air bladder 25 will push out the air inside the limiting cavity 241 through the suction hole 242. The negative pressure effect is then released, so that the pressing ring 24 is separated from the end portion of the knife switch observation hole 3 in contact therewith, facilitating the removal of the detection camera 1 and reducing the damage to the detection camera 1 that may be caused by manual operation.

### Embodiment 5

On the basis of embodiment 4, as shown in FIGS. 6 and 7 in the drawings of the specification, a fixing magnet 23 is provided on the outer surface of the limiting ring 22 and is located in an inner region of the limiting cavity 241. The fixing magnet 23 is distributed annularly around a central axis of the limiting sleeve 21.

Specific workflow is as follows: on the basis of the specific workflow in embodiment 4, in a case where the monitoring convex block 11 is initially embedded into the knife switch observation hole 3 and is not stable, the fixing magnet 23 located on the limiting ring 22 of the outer ring of the monitoring convex block 11 moves towards the inner wall of the knife switch observation hole 3 due to the magnetic attraction between the fixing magnet 23 and the inner wall of the knife switch observation hole 3, driving the monitoring convex block 11 to shake to both sides and collide with the inner wall of the knife switch observation hole 3, which may easily cause damage to various components on the monitoring convex block 11. Therefore, in the initial state, the fixing magnet 23 is provided on an upper surface of the limiting ring 22 and located in the fixing cavity 221, which may be shielded by the pressing ring 24. The pressing ring 24 may be made of electromagnetic shielding material to limit the magnetic attraction between the fixing magnet 23 and the inner wall of the knife switch observation hole 3.

As the monitoring convex block 11 and the limiting ring 22 are stably embedded into the knife switch observation hole 3, the sliding of the pressing ring 24 exposes the fixing magnet 23 located on the outer ring surface of the limiting ring 22, and the magnetic attraction limit fixing function is exerted. At this time, the monitoring convex block 11 and the knife switch observation hole 3 maintains stable due to the action of the limiting ring 22 and the fixing cavity 221. The bulge of the fixing cavity 221 maintains a gap between the exposed fixing magnet 23 and the corresponding inner wall of the knife switch observation hole 3, so that the fixing magnet 23 plays a magnetic fixing role, and the damage caused by collision between the monitoring convex block 11 and the inner wall of the knife switch observation hole 3 may be avoided. During the removing process, due to the gap effect, the fixing magnet 23 is not in direct contact with the inner wall of the knife switch observation hole 3, reducing the friction resistance received by the limiting ring 22 when sliding away, thereby making the removing of the detection camera 1 more smooth.

### Embodiment 6:

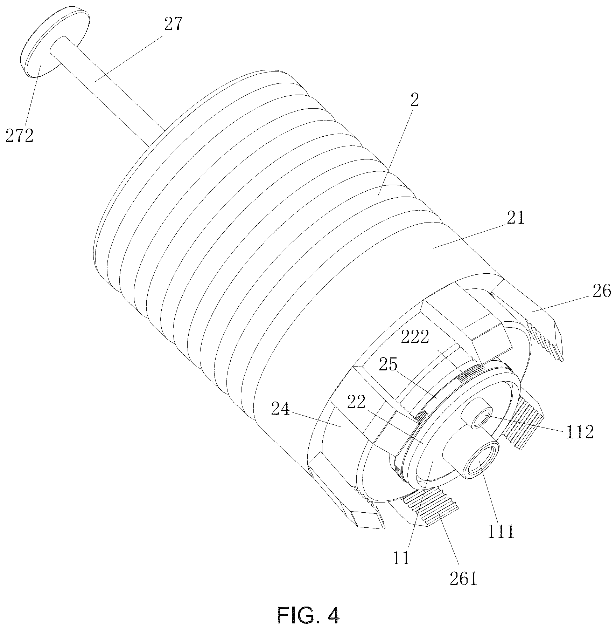

On the basis of the embodiment 5, as shown in FIGS. 4 to 7 in the drawings of the specification, a fixing claw 26 is provided at an end portion of the limiting sleeve 21 and is located outside the pressing ring 24, and the fixing claw 26 is made of an elastic material. Anti-slip blocks 261 are uniformly arranged on an inner surface of the fixing claw 26, and each anti-slip block 261 has a sharp end portion and is made of a rubber material.

Specific workflow is as follows: based on the specific workflow in embodiment 5, in the initial state, an end portion of the fixing claw 26 is proximate to the end portion of the pressing ring 24. As the pressing ring 24 is retracted due to pressure during the installation process, the fixing claw 26 protrudes with respect to the end portion of the knife switch observation hole 3. Since the end portion of the knife switch observation hole 3 protrudes with respect to the closed chamber, the fixing claw 26 which also protrudes is embedded on the outer ring surface of the end portion of the knife switch observation hole 3. The end portion of the fixing claw 26 may be provided with a magnet which has a weaker magnetism than that of the fixing magnet 23, so that the end portion of the fixing claw 26 is proximate to and in tight contact with the outer ring surface of the end portion of the knife switch observation hole 3. The anti-slip block 261 will also be in tight contact with the outer ring surface, so that the fixing claw 26 drives the detection camera 1 to engage with the protrusion at the end portion of the knife switch observation hole 3, further ensuring the limit fixing effect on the detection camera 1.

### Embodiment 7

On the basis of embodiment 6, as shown in FIGS. 1 to 6 in the drawings of the specification, a cleaning rod 27 is provided on an end portion of the limiting sleeve 21 away from the limiting ring 22, a cleaning block 271 is provided on an end portion of the cleaning rod 27. The cleaning block 271 has a circular plate structure, a surface of the cleaning block 271 is less than a cross-section of the camera hole 32 by 2 mm to 3 mm, inclusive. An outer surface of the cleaning block 271 is wrapped by a cleaning sleeve 272 which is made of chemical fiber or cotton cloth.

Specific workflow is as follows: on the basis of the specific workflow in embodiment 3, external dust may adhere to the corresponding sealing glass in the camera hole 32 due to electrostatic action in an electromagnetic environment. Therefore, before the monitoring operation starts, firstly the limiting sleeve 21 is taken, the cleaning rod 27 on the limiting sleeve 21 is aligned with the knife switch observation hole 3 and is embedded therein. The cleaning liquid is adhered to a surface of the cleaning sleeve 272, and the cleaning liquid may be a special cleaning product for electric-switch equipment to avoid negative impact on the equipment. The cleaning rod 27 is rotated to make the cleaning sleeve to wipe the surface of the sealing glass and cleans up dust that may adhere thereto, ensuring the cleanliness of the sealing glass, thereby ensuring that the image captured by the detection camera 1 is clear and thus the judgment result is more accurate.

The basic concept, main features and advantages of the present disclosure have been shown and described above. Those skilled in the art should understand that the present disclosure is not limited by the embodiments described above, and the descriptions in the embodiments described above and in the specification are only to illustrate the concept of the present disclosure. Various modifications and improvements without departing from the concept of the present disclosure can be made, which should fall within the scope of the present disclosure. The scope of the present disclosure is defined by the appended claims and their equivalents.

## Claims

1. A portable and handheld device for rapidly detecting a state of GIS, comprising: a detection camera (1), a GIS detection tablet, an image analysis module, a data transmission module, and a fixing and limiting module (2); wherein an end portion of the detection camera (1) protrudes to form a monitoring convex block (11), a camera lens (111) and a fill light (112) are provided on the monitoring convex block (11), the monitoring convex block (11) is embedded into a knife switch observation hole (3), the camera lens (111) and the fill light (112) are embedded into a camera hole (32) and a fill light hole (31) in the knife switch observation hole (3), respectively, a protective cover (113) is sleeved on an outside of the monitoring convex block (11);
the data transmission module is configured to transmit an image information captured by the detection camera (1) to the GIS detection tablet, the image analysis module is deployed on the GIS detection tablet and configured to analyze the image information and determine a position change of a knife switch to be detected;
the fixing and limiting module (2) is configured to assist the detection camera (1) to be fixed in the knife switch observation hole (3), wherein the fixing and limiting module (2) includes a limiting sleeve (21), and the limiting sleeve (21) is in a shape of a cylinder and wraps around an outside of the detection camera (1); and
a limiting ring (22) wrapping around the monitoring convex block (11) is disposed at an end portion of the limiting sleeve (21), a fixing magnet (23) is disposed on an outer surface of the limiting ring (22), and an outer ring surface of the limiting ring (22) is made of an elastic material.

2. The portable and handheld device for rapidly detecting the state of GIS according to claim 1, wherein a sliding groove (211) is provided on an inner sidewall of the limiting sleeve (21) proximate to the limiting ring (22), a pressing ring (24) is mounted on an annular opening portion of the limiting sleeve (21) proximate to the limiting ring (22);
a vertical cross-section of the pressing ring (24) is in an L-shape, an end of the pressing ring (24) is embedded into the sliding groove (211) and is slidably connected to the sliding groove (211), and another end of the pressing ring (24) is in contact with an outer surface of the limiting ring (22); and
a region surrounded between the pressing ring (24) and the limiting ring (22) defines a limiting cavity (241), a portion of an outer ring of the limiting ring (22) is hollow and defines a fixing cavity (221), and the limiting cavity (241) is in communication with the fixing cavity (221).

3. The portable and handheld device for rapidly detecting the state of GIS according to claim 2, wherein a limiting air bladder (25) is provided in the limiting cavity (241), the limiting air bladder (25) has an annular shape and is in communication with an interior of the fixing cavity (221) through a connecting pipe (251), and a control valve is provided in a middle portion of the connecting pipe (251).

4. The portable and handheld device for rapidly detecting the state of GIS according to claim 3, wherein limiting bumps (222) are uniformly arranged on an outer surface of a side wall of the fixing cavity (221), and an end portion of each of the limiting bumps (222) is inclined in a direction away from the camera hole (32).

5. The portable and handheld device for rapidly detecting the state of GIS according to claim 2, wherein a suction hole (242) is provided on a portion of the pressing ring (24) facing a surface of an end portion of the knife switch observation hole (3), and the suction hole (242) is in communication with the fixing cavity (221).

6. The portable and handheld device for rapidly detecting the state of GIS according to claim 5, wherein a sealing ring (243) made of an elastic material is disposed on an outer surface of the suction hole (242).

7. The portable and handheld device for rapidly detecting the state of GIS according to claim 2, wherein the fixing magnet (23) is provided on the outer surface of the limiting ring (22) and is located in an interior region of the limiting cavity (241), and the fixing magnet (23) is distributed annularly around a central axis of the limiting sleeve (21).

8. The portable and handheld device for rapidly detecting the state of GIS according to claim 7, wherein a fixing claw (26) is provided at an end portion of the limiting sleeve (21) and is located outside the pressing ring (24), and the fixing claw (26) is made of an elastic material.

9. The portable and handheld device for rapidly detecting the state of GIS according to claim 8, wherein anti-slip blocks (261) are uniformly arranged on an inner surface of the fixing claw (26), and each of the anti-slip blocks (261) has a sharp end and is made of a rubber material.

10. The portable and handheld device for rapidly detecting the state of GIS according to claim 9, wherein a cleaning rod (27) is provided on an end portion of the limiting sleeve (21) away from the limiting ring (22), a cleaning block (271) is provided on an end portion of the cleaning rod (27), the cleaning block (271) has a circular plate structure and an outer surface of the cleaning block (271) is wrapped by a cleaning sleeve (272).
